(19) **Europäisches Patentamt**
**European Patent Office**
**Office européen des brevets**

(11) Veröffentlichungsnummer: **0 344 869 B1**

(12) **EUROPÄISCHE PATENTSCHRIFT**

(45) Veröffentlichungstag der Patentschrift:
09.10.91 Patentblatt 91/41

(51) Int. Cl.⁵: **G05D 23/24, B60N 2/00,** **A47C 7/74**

(21) Anmeldenummer: **89201434.1**

(22) Anmeldetag: **30.05.89**

(54) **Regelschaltung für elektrische Sitzheizungen, insbesondere von Kraftfahrzeugen.**

Verbunden mit 89906079.2/0374228 (europäische Anmeldenummer/Veröffentlichungsnummer) durch Entscheidung vom 03.09.90.

(30) Priorität: **03.06.88 DE 3818974**

(43) Veröffentlichungstag der Anmeldung:
**06.12.89 Patentblatt 89/49**

(45) Bekanntmachung des Hinweises auf die Patenterteilung:
**09.10.91 Patentblatt 91/41**

(84) Benannte Vertragsstaaten:
**AT BE CH DE ES FR GB IT LI LU NL SE**

(56) Entgegenhaltungen:
**EP-A- 0 028 794**
**EP-A- 0 148 655**

(56) Entgegenhaltungen:
**DE-A- 2 309 104**
**DE-A- 2 757 334**
**GB-A- 2 134 340**
**US-A- 4 086 466**

(73) Patentinhaber: **WÄRME- UND ELEKTROTECHNIK B. RUTHENBERG GMBH**
**Frankfurter Ring 125**
**W-8000 München 46 (DE)**

(72) Erfinder: **Lorenzen Guenter, Dipl. Ing.**
**Futapassstr. 7**
**W-8037 Olching (DE)**
Erfinder: **Ruthenberg Bodo, Dipl. Wirtschaftsing.**
**Stuttgarterstr. 2**
**W-8000 München 46 (DE)**

(74) Vertreter: **Baumann, Eduard, Dipl.-Phys.**
**Postfach 1201 Sattlerstrasse 1**
**W-8011 Höhenkirchen bei München (DE)**

EP 0 344 869 B1

## EP 0 344 869 B1

**Beschreibung**

Die Erfindung betrifft eine Regel schaltung gemäß Oberbegriff von Anspruch 1 für elektrische Sitzheizungen, insbesondere von Kraftfahrzeugen, mit einem ein elektrisches Heizelement enthaltenden Regelkreis, mit einer abhängig vom Widerstand des elektrischen Heizelementes erregten Meßeinrichtung und einer von deren Ausgang gesteuerten Schalteinrichtung zum Abschalten des elektrischen Heizelementes. Eine derartige Regelschaltung ist aus DE-A1-2757334 bekannt.

Aus DE-A1-2757334 ist eine reine Regelschaltung für den Heizstrom von Sitzheizungen bekannt. Hierbei wird der Heizstrom periodisch unterbrochen, und zwar über einen Taktgenerator TG und einen Schalter S. Über eine weitere Spannungsquelle SG und eine Spannungsregelung SpR wird eine erheblich niedrigere Meßspannung an den Heizleiter RH angeschaltet. Der gemessene Widerstand dient unmittelbar als Istwert für die Temperaturregelung TR und wird dort mit einem einstellbaren Sollwert eines Sollwertgebers SWG verglichen. Damit der Vergleichswert nach dem Einschalten des Heizstromes entsprechend geregelt werden kann, muß der Vergleichswert in einer Speichereinrichtung SP der Temperaturregelung gespeichert werden. Ein Verknüpfungsglied VG liefert nur dann ein Signal an den Schalter S, wenn der über die Leitung L1 zugeführte Speicherwert anzeigt, daß die Temperatur noch nicht erreicht ist.

Bei Sitzheizungen, welche, beispielsweise nahe dem Sitzüberzug, elektrische Heizelemente enthalten, die von Heizdrähten gebildet sind, welche an einem Träger etwa nach einem Mäandermuster, in Zickzacklinien oder dergleichen angebracht sind, können unter der Beanspruchung während des Gebrauches Kurzschlüsse oder Unterbrechungen der Heizleiter auftreten. Kurzschlüsse, welche bestimmte Längenabschnitte des Heizleiters in dem elektrischen Widerstandsheizelement der Sitzheizungen überbrücken, führen zu einer erhöhten Stromaufnahme und zur Ausbildung heißer Stellen der beheizten Sitzfläche oder Rückenlehnenfläche, wobei diese Fehler von Regelkreisen zur Steuerung der Leistungszufuhr zur Sitzheizung nicht wahrgenommen werden können, wenn eine Überhitzung in Bereichen des elektrischen Widerstandsheizelementes auftritt, welche nicht mit einem Temperaturfühler des Regelkreises thermisch gekoppelt sind.

Zur Vermeidung dieser Schwierigkeiten wurde bereits der Heizstrom durch das elektrische Widerstandsheizelement mittels einer geeigneten Meßeinrichtung überwacht, welche ein die Abschaltung des elektrischen Heizelementes bewirkendes Signal abgibt, wenn der Heizstrom beispielsweise aufgrund interner Kurzschlüsse innerhalb der Sitzheizungen über einen bestimmten Pegel ansteigt, wie beispielsweise aus DE-A-2309104 bekannt.

Eine solche Regelschaltung hat jedoch den Nachteil, dass die Meßeinrichtung auf die Größe des Stromes durch das elektrische Widerstandsheizelement entsprechend der jeweiligen Heizleistung ausgelegt werden muss, oder dass, falls das elektrische Heizelement mit Wechselstrom gespeist wird, verhältnismässig komplizierte und teuere Stromwandler eingesetzt werden müssen, wenn ein für den Heizstrom repräsentativer, kleinerer Meßstrom abgeleitet werden soll.

Durch die Erfindung soll eine Regel schaltung für elektrische Sitzheizungen der eingangs kurz beschriebenen Art so ausgebildet werden, dass Fehler des elektrischen Widerstandsheizelementes, und zwar interne Kurzschlüsse, die zu örtlichen Überhitzungen führen, und Stromunterbrechungen zuverlässig und äusserst rasch in einer mit nur sehr geringen Meßströmen arbeitenden, einfachen Meßeinrichtung ermittelt werden können und zur Abschaltung der Sitzheizung führen. Eine solche Regel schaltung soll auf eine Vielzahl möglicher Fehler der elektrischen Sitzheizung ansprechen und diese Fehler in einem weiten Bereich von Betriebszuständen erfassen.

Diese Aufgabe wird erfindungsgemäss durch die Merkmale des Anspruches 1 gelöst.

Während die Überprüfung einer Schaltung in Pausen des normalen Betriebes auf anderen Gebieten ansich bekannt ist, wird bei der hier angegebenen Regel- und Überwachungsschaltung für elektrische Sitzheizungen eine kurze Unterbrechung der Leistungszufuhr zum elektrischen Widerstandsheizelement während Zeiten vorgesehen, während welchen auch bei einer thermostatischen EIN-AUS-Regelung das elektrische Widerstandsheizelement eingeschaltet ist. Aufgrund der thermischen Trägheit des gesamten Systems werden die kurzzeitigen Unterbrechungen der Leistungszufuhr zum elektrischen Widerstandsheizelement praktisch nicht wahrgenommen und fallen auch wegen des Verhältnisses der Dauer der kurzzeitigen Unterbrechung gegenüber der Dauer etwa des Einschaltzyklus bei thermostatischer EIN-AUS-Regelung in Grössenordnungen von beispielsweise 1/500 nicht ins Gewicht.

Bedeutsam ist ferner, dass in der vorliegend angegebenen, während der kurzzeitigen Unterbrechung der Leistungszufuhr zum elektrischen Widerstandsheizelement wirksamen Meßeinrichtung Bezugsspannungsquellen vorgesehen werden können, deren Bezugsspannungen sich ähnlich verhalten wie der Spannungsabfall am elektrischen Widerstandsheizelement aufgrund des Meßstromes in verschiedenen unterschiedlichen Betriebszuständen des nicht fehlerbehafteten elektrischen Widerstandsheizelementes unmittelbar bei Inbetriebnahme, bei stark veränderlichen Aussentemperaturen, während des Aufheizens und dergleichen.

2

Im übrigen sind vorteilhafte Ausgestaltungen und Weiterbildungen der vorliegend angegebenen Regelschaltung in den dem Anspruch 1 nachgeordneten Patentansprüchen gekennzeichnet. Ein Ausführungsbeispiel wird im folgenden unter Bezugnahme auf die Zeichnung näher erläutert. Es stellen dar:

Fig. 1 ein schematisches Schaltbild einer Regel- und Überwachungsschaltung für elektrische Sitzheizungen, insbesondere von Kraftfahrzeugen, entsprechend dem hier angegebenen Schaltungsaufbau,

Fig. 2 einander entsprechende Zeitdiagramme der Temperatur des elektrischen Heizelementes bzw. der dem elektrischen Heizelement zugeführten elektrischen Leistung für eine thermostatische EIN-AUS-Regelung und

Fig. 3 ein mit stark vergrössertem Zeitmaßstab gezeichnetes Zeitdiagramm der am elektrischen Heizelement anliegenden Speisespannung in einem Zeitabschnitt, der in Figur 2 mit III-III gekennzeichnet ist.

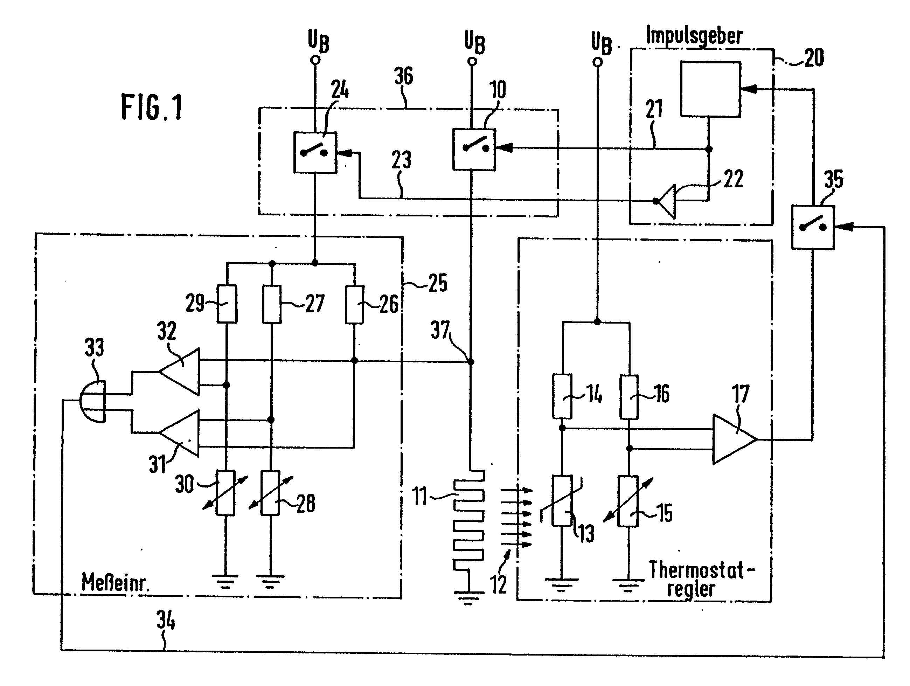

Die in Figur 1 gezeigte Schaltung kann über Schmelzsicherungen und über einen handbetätigten Schalter, welcher etwa am Armaturenbrett eines Kraftfahrzeuges installiert ist, mit der Bordspannung des Kraftfahrzeuges an den mit $U_B$ bezeichneten Klemmen beaufschlagt werden. Über einen Schalter 10, etwa in Gestalt eines Leistungs-Schalttransistors mit integriertem Übertemperaturschutz, ist ein elektrisches Widerstandsheizelement 11 der elektrischen Sitzheizung an die Bordspannung anschließbar. Das elektrische Widerstandsheizelement 11 kann entweder nur im Sitzpolster oder nur im Rückenlehnenpolster angeordnet sein oder auch aus Heizelementbestandteilen sowohl in der Rückenlehne als auch im Sitzpolster gebildet sein. Weiter versteht es sich, dass Regel- und Überwachungsschaltungen der vorliegend angegebenen Art auch jeweils gesondert für ein elektrisches Widerstandsheizelement des Sitzpolsters und ein elektrisches Widerstandsheizelement des Rückenpolsters in solcher Weise vorgesehen werden können, dass während des normalen Heizbetriebes das elektrische Widerstandsheizelement des Sitzpolsters und das elektrische Heizelement der Rückenlehne wahlweise einzeln eingeschaltet oder in Serie oder parallel betrieben werden, während zur Überprüfung der Unversehrtheit der elektrischen Widerstandsheizelemente diese jeweils gesondert mit einem von der weiter unten genauer beschriebenen Meßeinrichtung bereitgestellten Meßstrom beaufschlagt und überprüft werden.

Mit dem elektrischen Widerstandsheizelement ist thermisch in der durch die Pfeile 12 angedeuteten Weise ein Temperaturfühlerwiderstand 13 gekoppelt, dessen elektrischer Widerstandswert sich abhängig von der Temperatur des Widerstandes 13 aufgrund der thermischen Kopplung mit dem elektrischen Widerstandsheizelement 11 ändert. Der Temperaturfühlerwiderstand 13 ist Bestandteil eines ausserdem den Widerstand 14 enthaltenden Spannungsteilers, welcher bei Inbetriebsetzung der Sitzheizung an die Bordspannung angeschlossen wird. Die Teilerspannung des aus den Widerständen 13 und 14 gebildeten Spannungsteilers wird mit einer Bezugsspannung verglichen, die von einem Spannungsteiler aus den Widerständen 15 und 16 abgegriffen wird. Diese Bezugsspannung ist mittels des einstellbaren Widerstandes 15 veränderbar. An dem Widerstand 15 kann somit ein Sollwert der thermostatischen EIN-AUS-Regelung eingegeben werden.

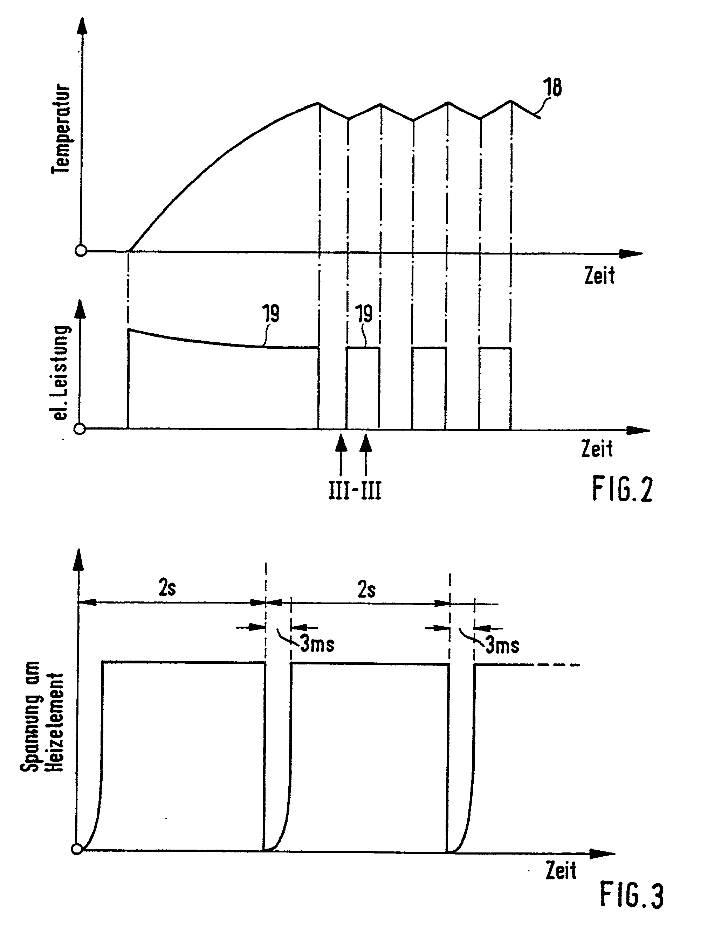

Die Teilerspannungen des Spannungsteilers aus den Widerständen 13 und 14 einerseits sowie 15 und 16 andererseits werden in dem Vergleicher 17 miteinander verglichen und das Ausgangssignal des Vergleichers 17 bewirkt über eine Schaltungsverbindung zu dem Schalter 10, dass dieser die Verbindung des elektrischen Widerstandsheizelementes 11 zu der Bordspannung unterbricht, wenn die von dem Fühlerwiderstand 13 aufgenommene Temperatur über einen Sollwert ansteigt, während die Verbindung des elektrischen Widerstandsheizelementes 11 zu der Bordspannung durch den Schalter 10 wiederhergestellt wird, wenn der Temperaturfühlerwiderstand 13 ein Abfallen der Heiztemperatur unter den sollwert meldet. Aufgrund einer der Regelung innewohnenden Hysterese ergeben sich die in Figur 2 gezeigten Kennlinien 18 bzw. 19 des Verlaufes der Temperatur des elektrischen Widerstandsheizelementes 11 bzw. des Verlaufes der zugeführten elektrischen Leistung jeweils in Abhängigkeit von der Zeit.

Bei der Ausführungsform nach Figur 1 veranlasst das Ausgangssignal des Vergleiches 17 in einem Betriebszustand, der eine Verbindung des elektrischen Widerstandsheizelementes 11 mit der Bordspannung und damit eine Heizleistungszufuhr erfordert, dass ein Impulsgenerator 20 an einer Ausgangsleitung 21 Steuerimpulse von jeweils 1,997 Sekunden Dauer, getrennt von Impulspausen von 0,003 Sekunden Dauer abgibt. Die Steuerimpulse auf der Leitung 21 bewirken, dass der Schalter 10 das elektrische Widerstandsheizelement 11 jeweils für Folgen von Impulsen mit 1,997 Sekunden Dauer, getrennt von Impulsenpausen von 0,003 Sekunden Dauer (vorstehende Zeitangaben Beispiele!) an die Bordspannung legt, solange der Vergleicher 17 ein Ausgangssignal abgibt, das eine unter der Solltemperatur gelegene Temperatur des elektrischen Widerstandsheizelementes meldet. Ein derartiges Ausgangssignal des Vergleichers 17 hat beispielsweise während einer Aufheizphase nach Inbetriebsetzung der Sitzheizung eine Dauer von 60 Sekunden und danach beispielsweise jeweils im Anschluss an Heizpausen von etwa 6 Sekunden jeweils die Dauer kurzer Heizperioden von ebenfalls 6 Sekunden Dauer. Diese Zeitangaben stellen jedoch nur ein Beispiel zur Erläuterung der prinzipiellen Zusammenhänge dar, weshalb die in Figur 2 dargestellten Diagramme keine Maßstabsangaben enthalten und qualitativ zu verstehen sind.

Das auf der Leitung 21 auftretende Ausgangssignal des Impulsgebers 20 wird von dem Inverter 22 invertiert und gelangt über die Leitung 23 zu einem von dem Signal der Leitung 23 gesteuerten Schalter 24, welcher die Aufgabe hat, in Abhängigkeit von dem Signal der Leitung 23 die Bordspannung an eine Meßeinrichtung 25 kurzzeitig während der Impulspausen des Signales auf der Leitung 21 anzuschalten.

Die Meßeinrichtung 25 enthält einen Widerstand 26, welcher zusammen mit dem elektrischen Widerstandsheizelement 11 einen an der Bordspannung liegenden Spannungsteiler bildet, wenn der Schalter 10 die unmittelbare Verbindung des elektrischen Widerstandsheizelementes 11 zur Bordspannung aufgetrennt hat. Die von dem Spannungsteiler aus dem Widerstand 26 und dem elektrischen Widerstandsheizelement 11 abgreifbare Teilerspannung wird mit den Spannungen zweier Bezugsspannungsquellen verglichen, wobei die erste Bezugsspannungsquelle aus einem Widerstand 27 und einem veränderbaren Widerstand 28 und die zweite Bezugsspannungsquelle aus einem Spannungsteiler aus dem Widerstand 29 und einem veränderbaren Widerstand 30 besteht.

Der Vergleicher 31 liefert an seinem Ausgang ein Fehlermeldesignal, wenn der Widerstand während des elektrischen Widerstandsheizelementes 11 etwa aufgrund interner Kurzschlüsse unter einen bestimmten, an dem Widerstand 28 einstellbaren Sollwert abfällt, während der Vergleicher 32 ein Fehlermeldesignal abgibt, wenn der Widerstandswert des elektrischen Widerstandsheizelementes 11, etwa aufgrund von Unterbrechungen oder Querschnittseinschnürungen des Heizleiters über einen bestimmten, an dem Widerstand 30 einjustierbaren Wert ansteigt. Die Ausgangssignale der Vergleicher 31 und 32 werden von dem ODER Schaltelement 33 logisch miteinander verknüpft, so dass auf einer Leitung 34 ein Fehlermeldesignal auftritt, sobald der Widerstandswert des elektrischen Widerstandsheizelementes 11 ausserhalb eines bestimmten, mittels der Widerstände 28 und 30 wählbaren Bereichsfensters gelegen ist.

Das Fehlermeldesignal auf der Leitung 34 beaufschlagt einen Schalter 35, welcher, sobald das Fehlermeldesignal auftritt, die Verbindung zwischen dem Vergleicher 17 und dem Impulsgeber 20 unterbricht, so dass dieser keine dem Schalter 10 in Einschaltstellung bringenden Steuersignale auf der Leitung 21 abgibt und folglich dus elektrische Widerstandsheizelement 11 ausgeschaltet bleibt.

Aus Figur 3 ist erkennbar, dass die Impulspausen zwischen den Impulsen auf der Leitung 21 beispielsweise nur 3 Millisekunden Dauer haben, welche jedoch dazu ausreichen, mittels der Meßeinrichtung 25 den Zustand des elektrischen Widerstandsheizelementes 11 zu ermitteln. Die in Figur 3 betrachtete Zeitdauer des Verlaufes der am elektrischen Widerstandsheizelementes anliegenden Speisespannung während eines störungsfreien Betriebes entspricht der vergleichsweise kurzen Dauer zwischen den Zeitmarken III-III im Zeitdiagramm der elektrischen Leistung gemäss Figur 2.

Der Fachmann erkennt, dass die in Figur 1 gezeigte Schaltung vielfältig abgewandelt werden kann. Beispielsweise kann anstelle der Schalter 10 und 24 der Schalteranordnung, welche in Figur 1 mit 36 bezeichnet ist, an dem Schaltungspunkt 37 ein Umschalter vorgesehen werden, welcher von den Signalen der Leitung 21 des Impulsgebers 20 gesteuert wird. Die Meßschaltung 25 bleibt bei dieser Ausbildung der Schaltung nach Inbetriebsetzen der Einrichtung ständig mit der Bordspannung verbunden. Weiter können die Ausgangssignale der Meßeinrichtung und des Thermostatreglers zu ihrer logischen Verknüpfung unmittelbar dem Impulsgeber 20 zugeleitet werden.

## Patentansprüche

1. Regelschaltung für den Heizstrom von elektrischen Sitzheizungen, insbesondere in Kraftfahrzeugen, mit einer Heizstromquelle ($U_B$) für den Heizleiter (11), einer Meßstromquelle ($U_B$) zur Lieferung eines erheblich niedrigen Meßstromes an den Heizleiter (11), mit einer Unterbrecherschaltung (12-17 ; 35 ; 20, 21, 10) für den Heizstrom, und mit einer Meßeinrichtung (25) für den Widerstand des Heizleiters (11), die Vergleichseinrichtungen (31, 32) aufweist, um das gemessene Widerstands- Signal des Heizleiters (11) mit entsprechenden, von einstellbaren Sollwertgebern (27, 28 ; 29, 30) gelieferten Sollwertsignalen zu vergleichen, und mit einer Verknüpfungsschaltung (33) zur Erzeugung eines vom Vergleich abhängigen Ausgangssignales der Meßeinrichtung an eine Ausgangsleitung (34), dadurch gekennzeichnet,

a) daß das Ausgangssignal der Meßeinrichtung (25) ein Fehlersignal ist, das die Sitzheizung im Störfall ausschaltet,

b) daß ein erster Sollwertgeber (29, 30) einen ersten Wert entsprechend dem Kurzschluß- Widerstand des Heizleiters (11) liefert,

c) daß ein zweiter Sollwertgeber (27, 28) einen zweiten Wert entsprechend einem unterbrochenen Heizleiter (11) liefert,

d) daß die Verknüpfungsschaltung (33) eine Oder- Schaltung ist, die bei Anliegen eines Ausgangssignales an einer der beiden Vergleichseinrichtungen (31, 32), entsprechend einem Kurzschluß oder einer Unterbrechung des Heizleiters (11), ein Unterbrechungssignal an die Ausgangsleitung (34) liefert,

e) daß im Bereich des Heizleiters (11) ein temperaturabhängiger Widerstand (13) vorgesehen ist, der in einem Temperaturvergleicher (17) zur Lieferung eines entsprechenäen Ausgangssignales mit einem einstellbaren Temperatur- Sollwert verglichen wird,

f) daß das Ausgangssignal des Temperatur- Vergleichers (17) während seines Vorhandenseins entsprechend einer Temperatur des Heizleiters (11) unterhalb des eingestellten Sollwertes einen Impulsgeber (20) zur Abgabe eines Einschaltimpulses an den Schalter (10) für den Heizstrom veranlaßt,

g) daß beim Impulsgeber (20) zwischen zwei Einschaltimpulsen von jeweils vorzugsweise 1,997 sec Dauer ein kurzdauernder Ausschaltimpuls von vorzugsweise 0,003 sec Dauer vorgesehen ist,

h) daß der Impulsgeber (20) über eine weitere Ausgangsleitung und einen Inverter (22) lediglich während des Ausschaltimpulses ein Einschaltsignal an einen Meßschalter (24) liefert, derart, daß im wesentlichen gleichzeitig mit der Unterbrechung des Heizstromschalters (10) die Meßeinrichtung (25) betätigt wird.

2. Regelschaltung nach Anspruch 1, gekennzeichnet durch ein Schaltglied (35), über welches das Ausgangssignal des Temperaturvergleichers (17) dem Impulsgeber (20) zugeführt wird, und das durch das Ausgangssignal der Verknüpfungsschaltung (33) der Meßeinrichtung (25) in Form eines Fehlersignales gesperrt werden kann, so daß der Heizstrom abgeschaltet wird.

3. Regelschaltung nach Anspruch 1 oder 2, dadurch gekennzeichnet, daß die Meßeinrichtung (25) einen Widerstand (26) enthält, der mit dem elektrischen Heizleiter (11) während dessen Trennung von der Heizstromquelle ($U_B$) einen Spannungsteiler bildet, dessen Teilerspannung mit einer Bezugsspannung einer Bezugsspannungsquelle ($U_B$, 27, 28) in einem Vergleicher (31) zur Bildung des Ausgangssignales (34) der Meßeinrichtung (25) verglichen wird, derart, daß ein die Unterbrecherschaltung zum Abschalten des elektrischen Heizleiters (11) steuerndes Ausgangssignal (34) der Meßeinrichtung (25) auftritt, wenn der Spannungsabfall an dem elektrischen Heizleiter (11) aufgrund des Meßstromes unter die Bezugsspannung abfällt.

4. Regelschaltung nach Anspruch 3, dadurch gekennzeichnet, daß die Teilerspannung des den elektrischen Heizleiter (11) (11) enthaltenden Spannungsteilers (26, 11) mit einer weiteren Bezugsspannung einer weiteren Bezugsspannungsquelle ($U_B$, 29, 30) in einem weiteren Vergleicher (32) zur Bildung des Ausgangssignales (34) der Meßeinrichtung (25) verglichen wird, derart, daß ein die Unterbrecherschaltung zum Abschalten des elektrischen Widerstandsheizelementes steuerndes Ausgangssignal der Meßeinrichtung auftritt, wenn der Spannungsabfall an dem elektrischen Heizleiter (11) aufgrund des Meßstromes über die weitere Bezugsspannung ansteigt.

5. Regelschaltung nach einem der Ansprüche 1 bis 4, dadurch gekennzeichnet, daß der temperaturabhängige Widerstand (13) zusammen mit einem Serienwiderstand (14) ein Glied einer Brückenschaltung im Thermostatregler bildet, dessen anderes Glied durch einen einstellbaren Widerstand (15) und einen dazu in Serie geschalteten Widerstand (16) gebildet wird, wobei die beiden Brückenglieder an die Heizstromquelle ($U_B$) angeschlossen sind und zwischen den beiden zugeordneten Widerständen dem Temperaturvergleicher (17) zugeführt sind, derart, daß das andere Brückenglied den Sollwert für die Temperatur des Heizleiters (11) bildet.

6. Regleschaltung nach Anspruch 4 oder 5, dadurch gekennzeichnet, daß die Unterbrecherschaltung (10, 24, 36) derart gesteuert ist, daß die normalerweise kurzzeitige Unterbrechung der Verbindung des elektrischen Heizleiters (11) mit der Heizstromquelle ($U_B$) eine Dauer von etwa 1/2000 bis 1/500 der Dauer des eine Einschaltung des elektrischen Heizleiters (11) bewirkenden Signals des Thermostatreglers hat.

## Claims

1. A controlling circuit for the heating current of electrical seat heating means, especially for automotive vehicles, comprising a source of heating current ($U_B$) for the heating conductor (11), a source of measuring current ($U_B$) for supplying a substantially lower measuring current to the heating conductor (11), further comprising an interruption circuit (12-17 ; 35 ; 20, 21, 10) for the heating current, and further comprising a measuring section (25) for measuring the resistance of the heating conductor (11) and including comparator means (31, 32) for comparing the measured resistance signal from the heating conductor (11) with corresponding reference signals provided from settable reference voltage sources (27, 28 ; 29, 30), and comprising a logic circuit (33) for providing in response to said comparison an output signal from the measuring section on an output line (34), characterised in

(a) that the output signal from the measuring section (25) is an error signal fog turning off the seat heating means in case of failure,

(b) that a first reference voltage source (29, 30) provides a first reference value corresponding to the short-circuit impedance of the heating conductor (11),

(c) that a second reference voltage (27, 28) provides a second value corresponding to an interrupted heating conductor (11),

(d) that the logic circuit (33) is an OR-circuit which supplies an interruption signal to the output line (34) when an output signal corresponding to a short-circuit or an interruption of the heating conductor (11) is present at either of the two comparator means (31, 32),

(e) that a thermistor (13) is provided in the vicinity of the heating conductor (11) which is compared in a temperature comparing means (17) with an adjustable reference temperature for providing a corresponding output signal,

(f) that the output signal from the temperature comparing means (17) while existing in accordance with a temperature of the heating conductor (11) below the set reference value causes a pulse generator (20) to provide an ON pulse to the switch (10) for the heating current,

(g) that between two respective ON pulses from the pulse generator (20) each having a duration of preferably 1.997 s there is provided a short OFF pulse having a duration of preferably 0.003 s,

(h) that the pulse generator (20) supplies on ON signal to a measuring switch (24) via a further output line and an inverter (22) only during the OFF pulse such that the measuring section (25) is energized substantially concurrently with the interruption of the heating switch (10).

2. Controlling circuit as claimed in claim 1, characterised by a switching device (35) through which the output signal from the temperature comparator (17) is supplied to the pulse generator (20) and which is adapted to be de-energised by the output signal from the logic circuit (33) of the measuring section (25) in the form of an error signal so that the heating current is turned off.

3. Controlling circuit as claimed in claim 1 or claim 2, characterised in that the measuring section (25) includes a resistor (26) forming a voltage divider with the electrical heating conductor (11) while the latter is disconnected from the source of heating current ($U_B$), the divider voltage of said voltage divider being compared with a reference voltage from a source of reference voltage ($U_B$, 27, 28) in a comparator (31) for producing the output signal (34) from the measuring section (25) such that an output signal (34) from the measuring section (25) for controlling the interruption circuit for interrupting the electrical heating conductor (11) occurs when the voltage drop across the electrical heating conductor (11) falls below the reference voltage in response to the measuring current.

4. Controlling circuit as claimed in claim 3, characterised in that the divider voltage of the voltage divider (26, 11) including the electrical heating conductor (11) is compared with another reference voltage from another source of reference voltage ($U_B$, 29, 30) in another comparator (32) for providing the output signal (34) from the measuring section (25) such that an output signal from the measuring section for turning off the electrical heating conductor occurs when the voltage drop across the electrical heating conductor (11) exceeds said other reference voltage in response to the measuring current.

5. Controlling circuit as claimed in any one of the claims 1 to 4, characterised in that the thermistor (13) together with a series resistor (14) constitutes a member of a bridge circuit in the thermostat the other member of which is constituted by a variable resistor (15) and a resistor (16) connected in series thereto, the said two bridge members being connected to the source of heating current ($U_B$) and being connected to the temperature comparator (17) between the two associated resistors such that said other bridge member provides the reference value for the temperature of the heating conductor (11).

6. Controlling circuit as claimed in claim 4 or claim 5, characterized in that the interrupting circuit (10, 24, 36) is controlled such that the normally short-duration breaking of the connection between the electrical heating conductor (11) and the source of heating current ($U_B$) has a duration of about 1/2000 to 1/500 of the duration of the signal from the thermostat which causes the electrical heating conductor (11) to be turned on.

## Revendications

1. Circuit de régulation pour chauffage électrique de siège, en particulier pour automobiles, comprenant une source de tension principale ($U_B$) pour le conducteur chauffant (11), une source de tension de mesure ($U_B$) fournissant au conducteur chauffant (11) un courant de mesure très inférieur, un circuit interrupteur (12-17 ; 35 ; 20, 21, 10) pour le courant de chauffage, et un dispositif de mesure (25) de la résistance du conducteur chauffant (11) doté de comparateurs (31, 32) destinés à comparer le signal de mesure de la résistance du conducteur chauffant (11) avec des signaux correspondant aux valeurs de consigne fournies par des ajusteurs de consigne (27, 28 ; 29, 30), et un circuit logique (33) fournissant à une ligne de sortie (34) un signal de sortie du dispositif de mesure fonction de la comparaison, caractérisé en ce que

a) le signal de sortie du dispositif de mesure (25) est un signal d'erreur qui met le chauffage de siège hors tension en cas de défaillance,

b) un premier ajusteur de consigne (29, 30) fournit une première valeur correspondant à la résistance de court-circuit du conducteur chauffant (11),

c) un deuxième ajusteur de consigne (27, 28) fournit une deuxième valeur correspondant à un conducteur chauffant (11) interrompu,

d) le circuit logique (33) est un circuit OU qui fournit un signal d'interruption à la ligne de sortie (34) lorsqu'un signal correspondant soit à un court-circuit, soit à un interruption du conducteur (11) est appliqué à l'un des deux comparateurs (31, 32),

e) est prévu dans la zone du conducteur chauffant (11) une résistance fonction de la température (13) dont la valeur est comparée par un comparateur de température (17) avec une valeur de consigne réglable,

f) pendant la durée de son existence correspondant à une température du conducteur chauffant (11), le signal de sortie du comparateur de température (17) commande un générateur d'impulsions (20) d'appliquer une impulsion de mise sous tension au commutateur (10) du courant de chauffage,

g) entre deux impulsions de mise sous tension d'une durée de préférence de 1,997 sec chacune, le générateur d'impulsion (20) émet une impulsion de mise hors tension d'une durée très courte de 0,003 sec,

h) pendant la seule durée de l'impulsion de mise hors tension, le générateur d'impulsions (20) fournit par l'intermédiaire d'une autre ligne de sortie et d'un inverseur (22) un signal de mise sous tension à un commutateur de mesure (24), de telle sorte que le dispositif de mesure (25) est actionné simultanément à l'interruption du courant par le commutateur de courant de chauffage (10).

2. Circuit de régulation selon la revendication 1, caractérisé par un élément commutateur (35) par lequel le signal de sortie du comparateur de température (17) est transmis au générateur d'impulsions (20), et qui peut être verrouillé par le signal de sortie du circuit logique (33) du dispositif de mesure (25) sous forme d'un signal d'erreur, de façon à débrancher le courant de chauffage.

3. Circuit de régulation selon la revendication 1 ou 2, caractérisé en ce que le dispositif de mesure (25) comprend une résistance (26) qui forme un diviseur de tension avec le conducteur électrique chauffant (11) pendant que celui-ci est déconnecté de la source de tension de chauffage ($U_B$), dont la tension de division est comparée avec la tension de référence d'une source de référence ($U_B$, 27, 28) dans un comparateur (31) en vue de générer un signal de sortie (34) du dispositif de mesure (25), de telle sorte qu'un signal de sortie (34) commandant l'interrupteur mettant hors tension le conducteur électrique chauffant (11) est émis par le dispositif de mesure (25) lorsque la chute de tension du conducteur électrique chauffant (11), telle que l'indique le courant de mesure, tombe au-dessous de la tension de référence.

4. Circuit de régulation selon la revendication 3, caractérisé en ce que la tension de division du diviseur de tension (26, 11) dont fait partie le conducteur électrique chauffant (11) est comparée à la tension de référence d'une autre source de référence ($U_B$, 29, 30) par un autre comparateur (32) en vue de générer le signal de sortie du dispositif de mesure (25), de telle sorte que le signal de sortie (34) commandant l'interrupteur mettant hors tension le conducteur électrique chauffant (11) est émis par le dispositif de mesure (25) lorsque la tension du conducteur électrique chauffant (11), telle que l'indique le courant de mesure, monte au-dessus de cette tension de référence.

5. Circuit de régulation selon l'une des revendications 1 à 4, caractérisé en ce que la résistance fonction de la température (13) forme avec une résistance en série (14) l'un des membres d'un pont du régulateur thermostatique dont l'autre membre est formé par une résistance réglable (15) et une résistance branchée en série (16), les deux membres du pont étant branchés sur la source de courant de chauffage ($U_B$) et raccordés au comparateur de température (17), de telle sorte que l'autre membre du pont constitue la valeur de consigne pour la température du conducteur chauffant (11).

6. Circuit de régulation selon la revendication 4 ou 5, caractérisé en ce que l'interrupteur (10, 24, 36) est commandé de telle sorte que la durée de l'interruption du raccordement du conducteur électrique chauffant (11) à la source de tension de chauffage ($U_B$) est normalement une fraction de 1/2000 à 1/500 de la durée du signal du régleur thermostatique causant la mise sous tension du conducteur électrique chauffant (11).

FIG.1

FIG.2

FIG.3